(19) Europäisches Patentamt
European Patent Office
Office européen des brevets

(11) **EP 2 211 458 B1**

(12) **EUROPEAN PATENT SPECIFICATION**

(45) Date of publication and mention
of the grant of the patent:
**25.01.2012 Bulletin 2012/04**

(51) Int Cl.:
**H03F 1/34** (2006.01)　　　**H03F 3/70** (2006.01)

(21) Application number: **09151425.7**

(22) Date of filing: **27.01.2009**

(54) **Charge amplifier with DC feedback sampling**

Ladungsverstärker mit DC-Feedback-Rückkopplung

Amplificateur de charge avec échantillonnage de retour CC

(84) Designated Contracting States:
**DE FR GB**

(43) Date of publication of application:
**28.07.2010 Bulletin 2010/30**

(73) Proprietor: **Freescale Semiconductor, Inc.**
**Austin, TX 78735 (US)**

(72) Inventors:
• **Mijuskovic, Dejan**
**Chandler, AZ 85248 (US)**

• **Fang, Deyou**
**Chandler, AZ 85286 (US)**

(74) Representative: **Ferro, Frodo Nunes et al**
**Freescale Semiconductor, Inc.**
**c/o Impetus IP Limited**
**Suite 57a, Basepoint Business Park**
**Caxton Close, Andover**
**Hampshire SP10 3FG (GB)**

(56) References cited:
**EP-A2- 0 325 903　　US-A- 4 887 470**
**US-A- 5 233 312　　US-A- 5 949 829**

Printed by Jouve, 75001 PARIS (FR)

**Description**

TECHNICAL FIELD

Embodiments of the subject matter described herein relate generally to charge amplifiers such as those used with capacitive accelerometers, gyroscopes and other systems utilizing capacitive sensing mechanisms. More particularly, various embodiments relate to charge amplifier circuits with a DC stabilization feedback loop.

BACKGROUND

"Charge Amplifiers" are any devices, circuits or systems capable of receiving an input charge signal and of driving an output voltage signal based on the input charge signal. Charge amplifier circuits and systems are used in many different applications. Vehicle airbag triggering devices, for example, often use capacitive accelerometers that commonly use charge amplifier systems to convert the charge output signal from the accelerometer to an output voltage signal that is used to determine the conditions for triggering the airbag. Other applications that use charge amplifiers include micro-electro-mechanical systems (MEMS) such as MEMS gyroscopes and MEMS accelerometers. Such devices are commonly used, for example, to measure movement in digital cameras and game console remotes. In many applications the signal input to the charge amplifier may not be suitable for direct use in measurement, processing, logic or other circuits because, among other reasons, the signal is typically in the form of a small capacitive charge signal and not a voltage signal. Conventional charge amplifiers therefore drive an output voltage signal that is more suitable for use by other circuits than the input charge signal itself.

Generally, charge amplifier systems include an operational amplifier with a capacitive feedback loop and a DC feedback loop. As a capacitive charge is applied at the input of the charge amplifier, the capacitive feedback loop changes its capacitive value and an amplifier drives a voltage to balance the change in capacitive value of the capacitive feedback loop. In this manner the charge amplifier produces a voltage output that is proportional to the capacitive charge input. There are many challenges, however, in designing and implementing charge amplifiers.

One of the challenges in designing charge amplifiers is reducing the phase error between the input charge signal and output voltage signal. One cause of the phase error in conventional charge amplifiers is from AC components of the output voltage signal passing through the DC feedback loop. Conventional charge amplifiers typically address this challenge by creating the effect of a low pass-filter that attenuates higher frequencies through the DC feedback loop using the resistor in the DC feedback path and the capacitance in capacitive feedback loop. Typically the phase error changes in proportion to a cut-off frequency from the low pass-filter effect, in that a lower cut-off frequency typically produces a lower phase error. In conventional charge amplifiers, the cut-off frequency of this filter and therefore the phase error are reduced as the product of the resistor value in the DC feedback loop and the capacitance value in the capacitive feedback loop increase.

Although a relatively large resistor is considered desirable in a conventional charge amplifier to reduce the cut-off frequency, it is a challenge to implement a large resistor on chip because many charge amplifiers, such as those implemented on a separate chip from the source of the input charge, need to supply leakage current at the signal input. It is typically difficult to implement a relatively large resistor on chip while supplying the leakage current for stabilizing the charge amplifier output through the relatively large resistor. Using a large capacitance in the capacitive feedback loop to reduce the cut-off frequency is also difficult to implement in a charge amplifier because the large capacitance in the capacitive feedback loop can undesirably decrease the signal level at the output of the charge amplifier, resulting in a low signal-to-noise ratio (SNR) at the charge amplifier output. To achieve a suitable cut-off frequency through the DC feedback loop, conventional charge amplifiers typically implement a relatively large resistor as a discrete component rather than on chip. Implementing the resistor as a discrete component, however, is generally disadvantageous in terms of cost and size.

A known prior art arrangement in EP-A-0325903 includes a charge amplifier circuit, in which measurements of an output signal are taken for the purpose of compensating drift. In '903, timing circuitry selects moments for taking samples of the level of the output signal that are well spaced in time from the occurrence of output pulses. The output pulses are separated by time intervals that may vary between each output pulse, and may vary greatly. One output sample is taken per inter-pulse space. EP-A-0325903 may work with a piezoelectric sensor that detects the angular rotation of an internal combustion engine crankshaft. Accordingly, it is desirable to provide a charge amplifier circuit with a resistor implemented on chip in a DC feedback loop that has a small phase-error and that also provides suitable current for the leakage current while providing a suitable output signal level and obtaining a suitable signal-to-noise ratio at the charge amplifier output. Other desirable features and characteristics will become apparent from the subsequent detailed description and the appended claims, taken in conjunction with the accompanying drawings and the foregoing technical field and background.

BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.

FIG. 1 is a block diagram showing an exemplary MEMS sensor system including a charge amplifier;

FIG. 2 is a block diagram of an exemplary DC feedback loop in a charge amplifier;

FIG. 3 is a circuit diagram of an exemplary charge amplifier circuit;

FIG. 4 is a graph of an exemplary output signal;

FIG. 5 is a block diagram of an exemplary synchronized sampler;

FIG. 6 is a circuit diagram of an exemplary sampler;

FIG. 7 is a graph showing waveforms related to an exemplary embodiment of a sampler; and

FIG. 8 is a flow chart of an exemplary method of operating a charge amplifier in a device.

DETAILED DESCRIPTION

The following detailed description is merely illustrative in nature and is not intended to limit the embodiments of the subject matter or the application and uses of such embodiments.

According to various embodiments, systems, circuits, and methods are described for improving the characteristics of a DC feedback loop in a charge amplifier circuit.

An exemplary embodiment provides a sampler in the DC feedback loop of a charge amplifier as discussed in further detail below. In the exemplary embodiment, a DC feedback loop in a charge amplifier includes a sampler to sample an AC signal with a DC offset at the output of the charge amplifier and to supply a DC voltage correlated to the DC offset. The sampler in the exemplary embodiment prevents components of an AC signal from passing through the DC feedback loop thereby reducing phase error.

In the exemplary DC feedback loop, the phase error introduced by the DC feedback loop can be reduced compared to conventional charge amplifiers because the sampler blocks AC signal components that have the same frequency as the input charge. In one embodiment the charge amplifier still provides leakage current through a first resistor implemented on chip as a smaller resistor than in conventional charge amplifiers. The first resistor and a capacitor in the capacitive feedback loop may be selected based on desired circuit attributes, with the sampler providing conditions for a low phase error. In addition to the above achievements, many embodiments provide suitable signal levels at the output of the charge amplifier to enable use in many other circuits.

Details of several exemplary embodiments will now be presented with particular reference to the drawing figures.

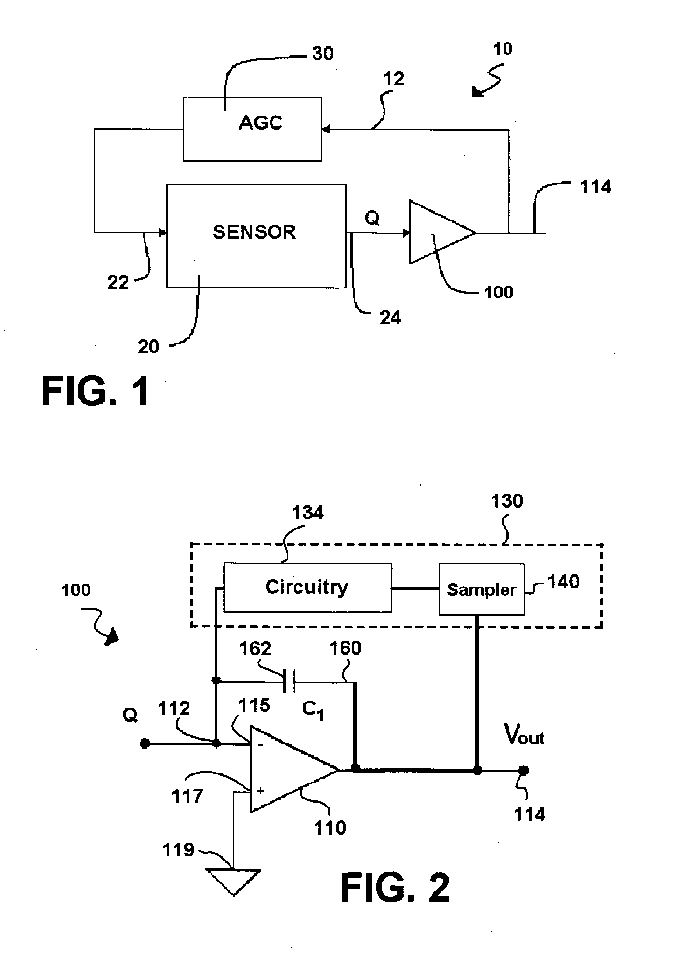

FIG. 1 is a block diagram of a sensor system 10 with feedback control. The sensor system of the exemplary embodiment has a MEMS sensor 20 with a MEMS input 22 and a MEMS output 24. A feedback loop 12 may include a charge amplifier 100 and an automatic gain control 30. In an exemplary embodiment charge amplifier 100 includes an output as a first amplifier output 114.

Sensor system 10 is any electronic system that senses an electronic phenomenon and has an output based on that phenomenon. In the example embodiment of FIG. 1, a sensor system 10 has a feedback loop 12. A MEMS gyroscope, for example, may have a feedback loop 12 to maintain an oscillating mass in the MEMS gyroscope. In alternative embodiments, sensor system 10 may operate in an open loop configuration in the absence of feedback loop 12. Photo detectors, CCD imaging devices, fiber optic receivers, and accelerometers, for example, may be used in a sensor system 10 without feedback loop 12. For the purpose of discussion, an exemplary sensor system 10 including a MEMS gyroscope will now be discussed, although other systems could be equivalently applied.

In various exemplary applications such as certain MEMS gyroscopes or accelerometers 20, a charge amplifier 100 has an input charge signal Q with a carrier frequency. The carrier frequency may be any suitable frequency, and in an exemplary embodiment is at a frequency selected from within a range of about 2kHz to about 20kHz. In one embodiment the MEMS gyroscope has a carrier frequency of about 12.5kHz. For a charge amplifier operating with a carrier signal input in this range, as well as other ranges, it has been identified that attenuating or blocking components of the AC signal at this frequency in the DC feedback loop is desirable to reduce phase error in the sensor system 10.

An exemplary MEMS sensor system 10 with a MEMS gyroscope will now be discussed in connection with one embodiment. In one embodiment, MEMS sensor 20 is a MEMS gyroscope with a MEMS output 24. A MEMS gyroscope includes an oscillating mass that oscillates at a frequency, for example at about 12.5kHz, although other embodiments could oscillate at another frequency. The MEMS gyroscope typically measures the change in the rotation of the oscillating mass in the form of a charge signal "Q". MEMS output 24 in many embodiments is a charge signal Q that is not typically suitable for direct use in logic circuits and other circuits. MEMS output 24 is therefore coupled to charge amplifier 100 to be converted to a voltage signal that is useful in other circuits. In the exemplary embodiment, charge amplifier 100 drives a voltage signal at the frequency of input charge signal Q, for example about 12.5kHz. Charge variations in the input carrier signal generally represent rotations of the gyroscope, although some charge variations may also represent imperfections in the many embodiments. Charge signal Q, including variations in the signal, can be converted to a suitable voltage signal by charge amplifier 100.

With charge signal Q from MEMS gyroscope 20 converted by charge amplifier 100 to a suitable voltage signal in exemplary MEMS sensor system 10, the voltage signal can be used in feedback loop 12 to drive the MEMS gyroscope oscillator. In most embodiments the voltage signal is used as an input to other circuits such as a logic or control circuit. First amplifier output 114 of charge amplifier 100 can be electrically coupled to an automatic gain control 30 as part of feedback loop 12. The voltage signal from charge amplifier 100 is therefore amplified to an appropriate level by automatic gain control 30. Automatic gain control 30 is coupled to MEMS input 22 to drive the oscillator at a desired frequency, for example about 12.5kHz. The variations in the voltage signal used for feedback may be used to correct for the imperfections in MEMS gyroscope 20. The variations may also be filtered or otherwise modified and then used to drive the oscillator in MEMS gyroscope 20. Exemplary embodiments of charge amplifier 100 are discussed below.

FIG. 2 shows charge amplifier system 100 including a first amplifier 110 with a DC feedback loop 130 that includes a sampler 140, and a capacitive feedback loop 160 that includes a first capacitor 162. DC Feedback loop 130 may also include DC stabilization circuitry 134. Charge amplifier 100 receives a capacitive charge signal Q and may have first amplifier 110 with a first amplifier input 112. Charge amplifier 100 suitably includes first amplifier output 114, which drives the output voltage signal $V_{out}$ of charge amplifier 100.

First amplifier 110 is any of a variety of amplifiers that drive an output voltage. In an exemplary embodiment, first amplifier 110 is a high gain differential amplifier with a negative differential input 115 and a positive differential input 117. Positive differential input 117 may be connected to a first reference voltage 119, such as the analog ground of a circuit. Other reference voltages may be used for first reference voltage 119, including for example, a negative side of the output from a MEMS gyroscope, or a common ground. First amplifier 110 in an exemplary embodiment drives the output voltage signal $V_{out}$ using capacitive feedback loop 160. The input charge signal may be integrated into capacitive feedback loop 160, and first amplifier 110 may drive a voltage signal to balance the charge in first capacitor 162 and bring the voltage potential at negative differential input 115 to the same value as first reference voltage 119 at positive differential input 117. In this manner first amplifier 110 in an exemplary embodiment, uses capacitive feedback loop 160 to drive an output voltage signal $V_{out}$ based on input charge signal Q. In one embodiment first amplifier 110 is a relatively high gain amplifier that provides a fast response time between changes in the input charge Q and corresponding changes in the output signal at first amplifier output 114 to reduce phase error between the input and output of charge amplifier 100.

Charge amplifier 100 in the exemplary embodiment of FIG. 2 suitably includes DC feedback loop 130 including sampler 140 for stabilizing the DC output of first amplifier 110. Sampler 140 is any device or component that samples an electrical input voltage and provides an output based on the samples. In an exemplary embodiment, sampler 140 samples output voltage signal $V_{out}$ over a time period and processes samples to drive a DC voltage signal. Sampler 140 may reduce the phase error of the charge amplifier by providing the same effect as a relatively low cut-off frequency in DC feedback loop 130. Sampler 140, for example, may block AC components of $V_{out}$ in a rage at or near the frequency of the signal by storing sampled voltages from $V_{out}$ and processing the sampled voltages to provide a DC output substantially equivalent to an output from a filter with a relatively low cut-off frequency for feedback in the carrier frequency range. Further details of exemplary embodiments of sampler 140 are discussed more fully below.

DC stabilization circuitry 134 is any suitable component or combination of components in DC feedback loop 130 used for DC stabilization. In an exemplary embodiment with charge amplifier 100 implemented on a separate chip from the source of input charge Q, DC stabilization circuitry 134 may include a resistor, and may drive current through the resistor to supply leakage current at the input to the charge amplifier. Unlike conventional charge amplifiers, stabilization circuitry 134 may be selected separately from a determination of a cut-off frequency in DC feedback loop 130 because sampler 140 may block AC components in the DC feedback loop 130 independently from stabilization circuitry 134. Stabilization circuitry in many embodiments can be implemented on chip providing a cost savings over conventional charge amplifiers.

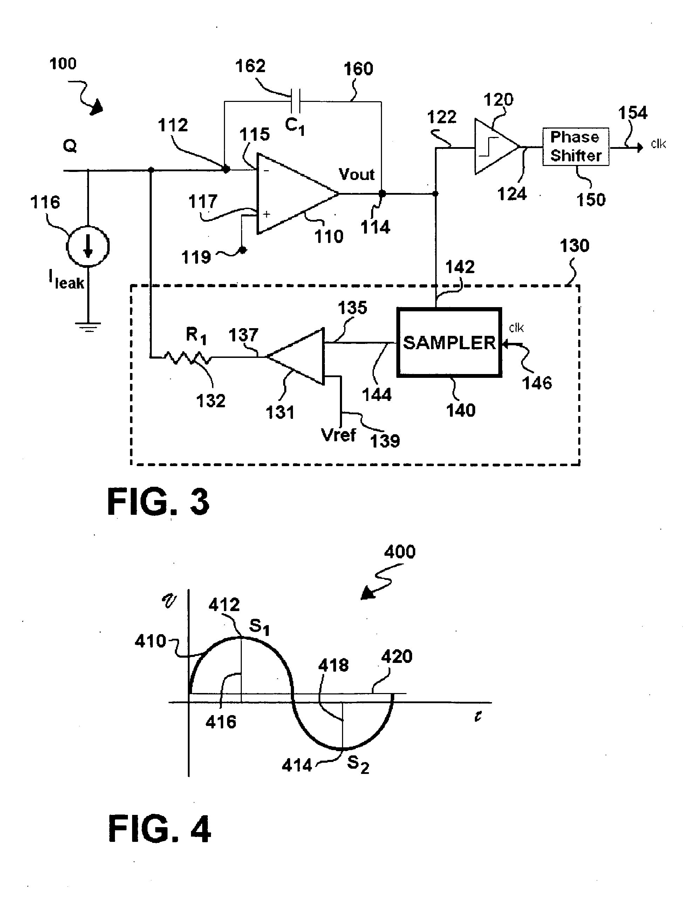

FIG. 3 shows additional details of one embodiment of charge amplifier 100 including details of one embodiment of stabilization circuitry 134 from FIG. 2. DC feedback loop 130 as shown in FIG. 3 suitably includes sampler 140 shown as a synchronous sampler, a second amplifier 131 and a first resistor 132. FIG. 3 also includes exemplary synchronization circuitry for synchronizing sampler 140, including a comparator 120 and a phase shifter 150. Sampler 140 may include a sampler clock input 146. Leakage current at the first amplifier input 112 may be represented as a current flowing to electrical ground, and is shown by way of illustration as $I_{leak}$ 116 in FIG. 3. Sampler 140 as shown includes a sampler input 142 and a sampler output 144. In one exemplary embodiment, sampler 140 produces a DC offset voltage at sampler output 144.

Second amplifier 131 is any suitable device or component that drives an appropriate output voltage based on an input voltage. Second amplifier 131 in an exemplary embodiment may provide a suitable voltage and current for the DC offset voltage. Sampler 140, for example, may sample using a digital process and have a digital output that is converted to an analog voltage signal with second amplifier 131 providing a suitable signal level and current for the output from sampler 140. Sampler output 144 in the exemplary embodiment is coupled to a second amplifier input 135 to drive an output voltage at a second amplifier output 137 that is based on the DC offset voltage at second amplifier input 135. Second amplifier output 137 may be coupled to first resistor 132 to supply leakage current through first resistor 132 and to feedback the DC offset voltage for DC stabilization to prevent the charge amplifier from driving into saturation.

Comparator 120 may be implemented in any suitable manner and may be a circuit component or the like that produces a clock signal. Comparator 120 of the exemplary embodiment of FIG. 3 includes a comparator input 122 and a clock signal at comparator output 124. In the exemplary embodiment comparator 120 converts sinusoidal signal at comparator input 122 into a clock signal at comparator output 124, so that the clock signal is synchronized and in phase with the input sinusoidal signal. Comparator 120 may be coupled to a phase shifter 150 that receives the clock signal from comparator output 124 and has a phase shifter output 154. Comparator 120 may receive output voltage signal $V_{out}$ as an input at comparator input 122 and produce a signal at the same frequency that is in phase with output voltage signal $V_{out}$. Comparator 120 in an exemplary embodiment is driven by output voltage signal $V_{out}$ so that the clock output is synchronized to output voltage signal $V_{out}$. In the exemplary embodiment sampler 140 may use the clock output from comparator 120 to determine a suitable frequency of sampling $V_{out}$. As discussed previously, sampler 140 in an exemplary embodiment samples voltages from output voltage signal $V_{out}$ over a time period and then processes the samples to drive a DC output voltage. If the sampling time period is very short relative to a cycle of the sampled output voltage signal $V_{out}$, then sampler 140 may pass AC components of output voltage signal $V_{out}$ through DC stabilization loop 130. If the sampling time period is very long relative to a cycle of the sampled output voltage signal $V_{out}$, then the charge amplifier 100 may not be sufficiently responsive to DC changes in output voltage signal $V_{out}$. With sampler 140 synchronized to output voltage signal $V_{out}$ in the exemplary embodiment, the sampling time period may be determined to provide a suitable sampling time period based on the cycle of output voltage signal $V_{out}$. In other embodiments comparator 120 may use other signals to produce a clock output signal, such as in a system that does not produce a regulated signal suitable for use as an input to comparator 120. Comparator 120 may be part of charge amplifier 100 or may be a separate circuit coupled to charge amplifier 100.

Phase shifter 150 is any device or component suitable for shifting the phase of a signal. Phase-shifter 150 may be implemented in any manner. In various embodiments phase-shifter 150 may be implemented as an integrator, a differentiator, a phase-locked-loop, a Hilbert transformer, and/or any other component. In one embodiment phase-shifter 150 produces a phase-shifted clock signal. In the exemplary embodiment, phase-shifter 150 provides a clock signal shifted by approximately ninety degrees. In other embodiments phase-shifter 150 provides a clock signal shifted by other values. In an exemplary embodiment phase shifter 150 shifts the phase of the clock signal from comparator 120 so that a clock signal is produced at phase shifter output 154 that has the same frequency as output voltage signal $V_{out}$, but with a phase shift. As discussed previously, sampler 140 may use a synchronized clock signal that is synchronized to the frequency of output voltage signal $V_{out}$. In one embodiment the clock signal is shifted in phase, and the phase shifted clock signal at phase shifter output 154 is used as an input at sampler clock input 146. In many embodiments input charge signal Q is in the form of a sine wave, and output voltage signal $V_{out}$ is similarly in the form of a sine wave. With the sampler synchronized to output voltage signal $V_{out}$ in the exemplary embodiment, sampler 140 may sample the same part of the signal in each cycle. In one embodiment this is done by shifting the clock signal by ninety degrees using phase shifter 154 so that a clock edge is aligned with a peak of the sine wave. Details of sampling in an exemplary embodiment will now be discussed in connection with FIG. 4.

An exemplary output voltage signal 410 or $V_{out}$ is shown in graph 400 of FIG. 4. In one embodiment output voltage signal $V_{out}$ is driven by charge amplifier 100 based on an oscillating output charge Q from a MEMS gyroscope 20. Output voltage signal $V_{out}$ may have the same frequency as the oscillating output charge Q. In the exemplary embodiment the DC offset of output voltages signal $V_{out}$ is caused by imperfections in the circuits including first amplifier 110. The exemplary output voltage signal 410 $V_{out}$ includes a first point 412 that may be a high peak and a second point 414 that may be a low peak. Output voltage signal 410 suitably includes a DC offset value 420. In one embodiment DC offset value 420 is approximately equal to an average of a first value $S_1$ 416 measured at first point 412 and a second value $S_2$ 418 measured at second point 414 according to the equation: DC offset = $(S_1 + S_2)/2$. Accordingly, in an exemplary embodiment sampler 140, using the phase shifted clock signal to align sampling to first point 412 and second point 414, samples at a high peak 412 and at a low peak 414 to obtain first value 416 and second value 418, and then averages first value 416 and second value 418 to obtain DC offset value 420.

Sampler 140 in DC feedback loop 130 may be implemented in any suitable manner for sampling output voltage $V_{out}$ 410. In the exemplary embodiment of FIG. 3, sampler 140 is a synchronous sampler synchronized with output voltage signal $V_{out}$ 410 that samples output voltage signal $V_{out}$ 410 and averages the samples over time to drive a DC voltage signal 420. The output voltage signal 410 $V_{out}$ may be sampled in a manner that produces an approximate value of the DC offset of output signal $V_{out}$. In the exemplary embodiment of FIG. 3, sampling is synchronized with the output voltage signal 410 $V_{out}$ so that in each cycle a sample is measured at approximately the same part of the cycle. Comparator 120, for example, may be synchronized with output voltage signal 410 to produce a clock signal that has the same phase and frequency of output voltage signal 410. Phase shifter 150 in the exemplary embodiment then shifts the phase of the clock signal so that a phase shifted clock signal is produced and can be used to sample output voltage signal 410 at the same part of each cycle. More details of synchronization circuits and methods in exemplary embodiments will be discussed below.

In an exemplary embodiment, the clock signal used to sample output voltage signal 410 is derived from output voltage signal 410 so that the frequency and phase of output voltage signal 410 can be correlated with sampling. A first sample $S_1$, for example, may be measured at first point 412 on the signal in the first half of the cycle. In many sinusoidal and other signals a corresponding second point 414 may be found and sampled as second sample $S_2$ that is approximately one-hundred-eighty degrees from first point 412. The first point 412 and the second point 414, when averaged together, may provide a result that is approximately the DC offset value 420 of output voltage signal 410 $V_{out}$, as described above.

With many signals, a high peak at first point 412 is found in the first half of the cycle at approximately ninety degrees from the beginning of the cycle, and a low peak at second point 414 is found at approximately two-hundred-seventy degrees from the beginning of the cycle. The low peak at second point 414 is also approximately one-hundred-eighty degrees from the high peak at first point 412. If a sinusoidal signal is sampled at ninety degrees and at two-hundred-seventy degrees, then the sampled values may be averaged to provide a DC offset value. For many signals, however, if the signal is sampled at a different first point than the high peak, and is also sampled at a corresponding second point on the signal such as one-hundred-eighty degrees from the first point, the sampled values may still be averaged to provide a DC offset value. Therefore sampler 140 of an exemplary embodiment can sample output voltage signal 410 and provide a DC offset value 420 by sampling within the first half of the cycle, and by sampling at a point in the second half of the cycle approximately one-hundred-eighty degrees from the first sample. The sampling of the exemplary embodiment is not dependent on the location of the first point measured (such as ninety degrees from the start) or on the peak-to-peak voltage of the signal, to provide a DC offset value of the signal. In alternative embodiments multiple points may be sampled in the first half of a cycle, and multiple points may be sampled from the second half of the cycle.

Phase error can be significantly reduced compared to conventional charge amplifiers by using sampler 140 in exemplary charge amplifier 100. In one exemplary embodiment of sensor system 10, MEMS gyroscope 20 may operate at a carrier frequency, for example a frequency of about 12.5kHz, although other values could be used in other embodiments. An exemplary charge amplifier 100 produces an output voltage signal 410 at first amplifier output 114, at the carrier frequency. DC feedback loop 130, in the exemplary embodiment, samples output voltage signal 410 at a rate of about 25kHz and drives a DC value based on the sampled signal. In this manner, sampler 140 in an exemplary embodiment blocks most if not all of the AC components of the output voltage signal 410, providing a phase error of 100urad or less for charge amplifier 100 in this example.

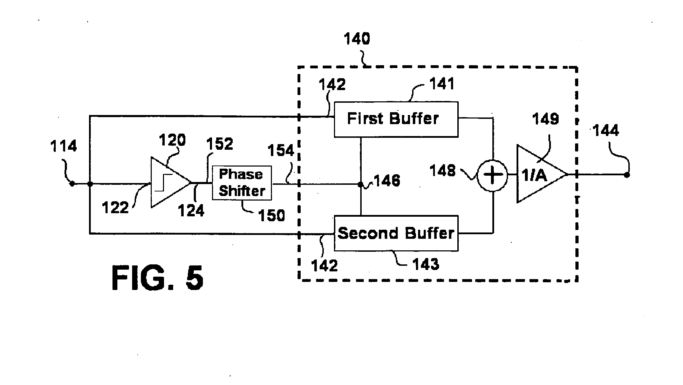

FIG. 5 shows one embodiment of sampler 140 as a synchronized sampler. Sampler 140 in the exemplary embodiment includes a first buffer 141 and a second buffer 143. First buffer 141 and second buffer 143 are suitably connected to sampler input 142 to sample output voltage signal 410 (shown in FIG. 4) from first amplifier output 114. First buffer 141 and second buffer 143 may also be connected to sampler clock input 146 to enable input and/or output of each buffer. In the exemplary embodiment, comparator 120 drives a synchronized clock signal at comparator output 124 based on output voltage received at comparator input 122. Phase shifter 150 receives the synchronized clock signal at phase shifter input 152 and drives a phase shifted clock signal at phase shifter output 154. The phase shifted clock signal may enable input to first buffer 141 at a high peak of the sampled signal, and input to second buffer 143 at a low peak of the sampled signal. Synchronization to the high and low peaks may be accomplished in any manner. In one exemplary embodiment the phase shifted clock signal may have a rising edge approximately aligned with a first peak, and a falling edge aligned with a second peak and may enable input to first buffer 141 at the rising edge and input to second buffer 143 at the falling edge. In the exemplary embodiment, first buffer 141 and second buffer 143 are connected to a summing node 148 that adds the values from the buffers. Sampler 140 may also have a sampler attenuator or divider circuit 149 that has a gain of 1/A, where A is the number of buffers that are summed at one time.

First buffer 141 and second buffer 143 may be implemented in any suitable manner for sampling. In an exemplary embodiment, first buffer 141 and second buffer 143 store first value 416 and second value 418 as capacitive values or charges. Other methods of storing sampled values may be performed in other embodiments. In an alternative embodiment, for example, first value 416 and second value 418 are converted to a digital value and are stored digitally.

Sampler 140 may sample output voltage signal 410 (shown in FIG. 4) at any suitable rate. In one embodiment, for example, sampler 140 samples output voltage signal 410 at first amplifier output 144 at a rate that is approximately twice the carrier frequency. In other embodiments, sampler 140 samples at a higher rate to obtain more than two samples per cycle, and suitably includes additional buffers as appropriate. Summing node 148 may be coupled to sampler clock input 146. In an exemplary embodiment, summing node 148 drives the DC offset voltage at sampler output 144 when first buffer 141 and second buffer 143 contain first value 416 and second value 418. DC offset voltage may be provided as a pulse at a suitable time and at a rate synchronized with the carrier frequency. Other methods of driving DC offset voltage may be used in other embodiments. DC offset voltage, for example, may alternatively be held with a sample and hold circuit and updated at a rate synchronized with the carrier frequency. In other embodiments additional buffers are used with multiple buffers storing the same value, with the DC offset voltage updated at a higher rate than the carrier frequency.

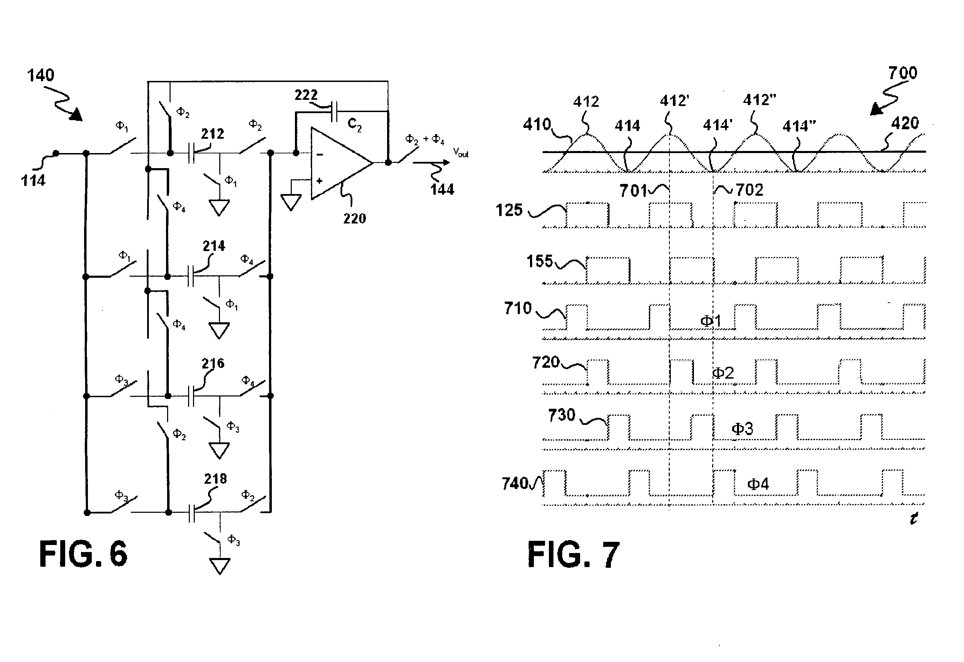

As discussed above, sampler 140 may be implemented in any suitable manner. One exemplary embodiment of sampler 140 is shown in FIG. 6. Exemplary waveforms related to FIG. 6 are shown in FIG. 7. The exemplary embodiment of FIG. 6 includes four buffers as capacitors, namely first sampler capacitor 212, second sampler capacitor 214, third sampler capacitor 216, and fourth sampler capacitor 218. Sampler 140 includes multiple gates controlled by four clock signals shown in FIG. 7 as phase one clock $\Phi_1$ 710, phase two clock $\Phi_2$ 720, phase three clock $\Phi_3$ 730, and phase four clock $\Phi_4$ 740. Gates labeled $\Phi_1$ close when phase one clock $\Phi_1$ 710 is at a high state, gates labeled $\Phi_2$ close when phase two clock $\Phi_2$ 720 is at a high state, gates labeled $\Phi_3$ close when phase three clock $\Phi_3$ 730 is at a high state, and gates labeled $\Phi_4$ close when phase four clock $\Phi_4$ 740 is at a high state. Exemplary sampler 140 shown in FIG. 6 also includes a sampler amplifier 220 and sampler feedback capacitor 222. Sampler amplifier 220 and sampler feedback capacitor 222 provide a charge amplifier to amplify the charges from buffer capacitors (212, 214, 216, and 218). In an exemplary embodiment output voltage signal $V_{out}$ to be sampled is received from first amplifier output 114, and the clock signal synchronized with output voltage signal $V_{out}$ is used to produce four clock signals for the four phases that are sequential non-overlapping clock signals (710, 720, 730, and 740).

In the exemplary embodiment of FIG. 6, gates labeled $\Phi_1$ close when output voltage signal $V_{out}$ is at high peak 412 so that first and second buffer capacitors 212 and 214 are coupled between first amplifier 110 and ground to store a charge related to the voltage at high peak 412. As seen in waveform graph 700, gates labeled $\Phi_1$ may be correlated to points (412, 412' and 412") which are high peaks of output voltage signal 410 so that gates labeled $\Phi_1$ close as output voltage signal 410 approaches a high peak, and open around the time that output voltage signal 410 reaches the high peak. In this manner first and second sampler capacitor 212 and 214 store a charge related to the high peak value of output voltage signal 410.

After the gates labeled $\Phi_1$ open in the exemplary embodiment, gates labeled $\Phi_2$ close and the charge in first buffer capacitor from the high peak 412 is combined with a charge in fourth buffer capacitor 218 (stored during a previous cycle during $\Phi_3$) and the combined charges are driven as a voltage by sampler amplifier 220. Amplifier 220 and sampler feedback capacitor 222 may be part of a sample-hold circuit so that when gates labeled $\Phi_2$ close the voltage at sampler output 144 is held. In one embodiment sampler amplifier 220 has a gain so that after the charges from the high peak and the low peak are combined, sampler output 144 drives an average of the voltage values from high peak 412 and low peak 414 that is approximately the same as DC offset 420. In alternative embodiments, the gain to produce a voltage that approximates DC offset 420 is the combined gain of sampler amplifier 220 and another amplifier, such as second amplifier 131 shown in FIG. 3.

After the gates labeled $\Phi_2$ open in the exemplary embodiment, the gates labeled $\Phi_3$ close when the output voltage signal $V_{out}$ is at a low peak to store a charge related to the low peak 414 in third buffer capacitor 216 and fourth buffer capacitor 218. In the exemplary embodiment of FIG. 7 the four gates labeled $\Phi_3$ close as output voltage signal 410 approaches a low peak and open around the time of the low peak so that values related to second, fourth and sixth points (414, 414' and 414") are stored in third sampler capacitor 216 and fourth sampler capacitor 218 at respective times of output voltage signal 410.

In the exemplary embodiment, gates labeled $\Phi_3$ then open and gates labeled $\Phi_4$ close and the charges from second buffer capacitor 214 storing a value from high peak 412, and third buffer capacitor 216 storing a value from low peak 414 are combined and driven as a voltage by sampler amplifier 220. In this manner sampler 140, in the exemplary embodiment, averages the sampled values from high peak 412 and low peak 414 and drives and average of the sampled values substantially equal to DC offset 420 during $\Phi_2$ and $\Phi_4$.

Sampler amplifier 220 may be any amplifier used to amplify a voltage. Sampler amplifier 220 is shown in the exemplary embodiments as a high gain operational amplifier and is shown as a differential amplifier, but may also be implemented as a fully differential amplifier or other type of amplifier.

In one embodiment the voltage at $V_{out}$ 144 during $\Phi_2$ and $\Phi_4$ is the dc value of the output voltage signal 410. Referring to FIG. 4, DC offset 420 has a DC value of $V_{dc}$, and output voltage signal 410 has an amplitude of $V_{amp}$, and high peak 412 is $V_{dc} + V_{amp}$, and low peak 414 is $V_{dc}-V_{amp}$-Referring to FIG. 6, in the exemplary embodiment sampler capacitors 212, 214, 216 and 218 have the same capacitance value $C_s$. At the time point when gates $\Phi_1$ open, charges stored on sampler capacitors 212 and 214 are $(V_{dc}+V_{amp})*C_s$. At the time point when gates $\Phi_3$ open, charges stored on sampler capacitors 216 and 218 are $(V_{dc}-V_{amp})*C_s$. When gates $\Phi_2$ close, charge stored on sampler capacitor 212 is combined and averaged with charge stored on sampler capacitor 218.

$$\text{Combined Charge} = (V_{dc}+V_{amp})*C_s + (V_{dc}-V_{amp})*C_s = 2V_{dc}*C_s = V_{dc}*2C_s.$$

The charge transferred during $\Phi_2$ in the exemplary embodiment is equal to $V_{dc}$ times $2C_s$, and is equivalent to sample voltage $V_{dc}$ with a sampling capacitance of $2C_s$. When gates $\Phi_2$ are closed, the sampled voltage $V_{dc}$ in the exemplary embodiment is holding on the output of amplifier 220. During $\Phi_4$, the combination and averaging of charges from sampler capacitors is the same as in $\Phi_2$.

Waveform graph 700 represents seven exemplary waveforms in simultaneous states. Broken lines 701 and 702 are drawn to show relationships between exemplary waveforms. FIG. 7 shows several exemplary signals including output voltage signal 410 from first amplifier output 114, synchronized clock signal 125 from synchronized comparator 120, phase-shifted clock signal 155 from phase shifter 150, and phase one through phase four clock signals (710, 720, 730, and 740). In the exemplary embodiment output voltage signal 410 is sampled by sampler 140 to provide DC offset voltage 420. In the exemplary embodiment, output voltage signal 410 is also used to synchronize a clock for sampling. Several points on output voltage signal 410 are discussed including first point 412, second point 414, third point 412', fourth point 414', fifth point 412", and sixth point 414".

Output voltage signal 410 may be any waveform that is an output from a charge amplifier. Output voltage signal 410 is shown as a sine wave, but waves of other shapes may be used as suitable output signals from charge amplifier 100.

Synchronized clock signal 125 may be any clock signal synchronized with output voltage signal 410. Synchronized clock signal 125, for example, may be produced by comparator 120 at comparator output 124 (shown in FIG. 3), and may have a waveform with a steep rising and falling edge. Synchronized clock signal 125 in the exemplary embodiment shown in FIG. 7 has a rising edge that is triggered from output voltage signal 410 going from a negative to a positive, passing dc value 420. A falling edge of synchronized clock signal 125 may also be triggered from output voltage signal 410, for example from output voltage signal passing the dc value 420 from positive to negative. Alternatively, the falling edge of synchronized clock signal 125 may be based on a duty cycle, such as a fifty percent duty cycle. Other duty cycles may be used for synchronized clock signal 125, and other methods of triggering and synchronizing may be used to synchronize a clock signal to a waveform.

Phase shifted clock signal 155 may be produced with phase shifter 150 at phase shifter output 154 (shown in FIG. 3), and may align a portion of phase-shifted clock signal 155 to another waveform. The exemplary waveforms of FIG. 7 show phase-shifted clock signal 155 shifted approximately ninety degrees from synchronized clock signal 125. By shifting the clock signal about ninety degrees in the exemplary embodiment, the rising edge of phase-shifted clock signal 155 is approximately aligned with a high peak of output voltage signal 410. Broken line 701 shows, for example, that one of the rising edges of phase-shifted clock signal 155 may be aligned with third point 412'. Similarly, as shown by broken line 702, falling edge of phase-shifted clock signal may be aligned to a low peak such as fourth point 414'. By aligning an edge of a clock signal to a peak in a waveform, the clock signal may be used to assist in sampling the waveform around the peak. Phase-shifted clock signal 155 may be shifted by other amounts, such as forty-five degrees, to align to other parts of a waveform.

Phase one through phase four clock signals (710, 720, 730, and 740) may be any suitable clock signals for activating switches. Alternatively, phase one through four clock signals (710, 720, 730 and 740) may not actually exist in an exemplary circuit, but may only represent switching in an exemplary circuit such as the circuit of FIG. 6.

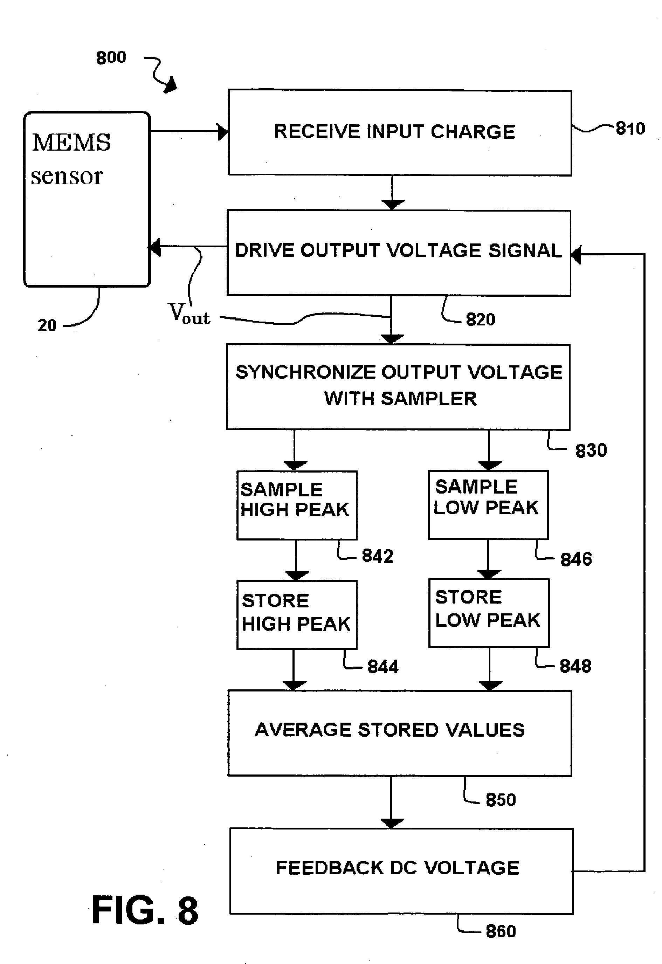

FIG. 8 shows an exemplary method 800 of operating a charge amplifier 100. Method 800 may be implemented in hardware, software, firmware, or any combination thereof, including any combination of digital and analog circuitry. In various embodiments, method 800 may be implemented with the circuitry and components as discussed above in connection with various figures and embodiments, although alternative embodiments may implement some or all of the steps of method 800 using other devices, circuitry, code, and/or logic.

Generally speaking, method 800 involves the broad steps of receiving an input charge (step 810), driving an output voltage signal (step 820), synchronizing the output voltage signal with a sampler (step 830), sampling a high peak from the output voltage signal (step 842), storing the sampled high peak (step 844), sampling a low peak from the output voltage signal (step 846), storing the sampled low peak (step 848), averaging the stored values (step 850) and feeding back a DC voltage (step 860). MEMS sensor 20 is shown in FIG. 8 to further facilitate discussion of exemplary method 800.

Beginning with step 810, charge amplifier 100 receives an input charge in any manner. As discussed above, input charge may be from a MEMS sensor 20, or from other components or devices. In an exemplary embodiment the input charge is a signal with a carrier frequency as discussed in exemplary embodiments above. Alternatively, the input charge may be a single charge, or intermittent charges of varying positive and/or negative values. In an exemplary embodiment, an input charge is received at a first amplifier input 112 as shown in FIG. 2.

In step 820 as shown in exemplary method 800 of FIG. 8, driving an output voltage signal $V_{out}$ is performed by any component and/or device designed to drive output voltage signal $V_{out}$. The inputs to the component or device driving output voltage signal $V_{out}$ may include the input charge signal received in step 810 and feedback voltage from step 860. Other inputs may be used as inputs to drive output voltage signal $V_{out}$. Output voltage signal $V_{out}$ in the exemplary method 800 is used to drive the MEMS sensor 20, which may be an oscillating MEMS gyroscope. In alternative embodiments, output voltage signal $V_{out}$ may be used to drive a separate device or display, to provide an input signal to a separate system, and/or may be further modified as appropriate. Output voltage signal $V_{out}$ in the exemplary method 800 is also used in a feedback loop such as a DC stabilization loop including the steps of sampling the output voltage signal 842 and 846, storing the sampled output voltage 844 and 848, averaging the stored values 850 and feeding back the DC voltage through a resistor 860.

In step 830 a clock is synchronized to the output voltage signal in any manner. In an exemplary embodiment of method 800, step 830 uses a synchronized clock signal with a ninety degree phase-shift from output voltage signal $V_{out}$ to align to a high peak and a low peak of output voltage $V_{out}$.

In steps 842, and 846 output voltage $V_{out}$ is sampled in any manner. In steps 844 and 848 sampled output voltages are stored in any manner. In an exemplary embodiment of method 800, steps 842, 844, 846, and 848 are implemented with sampling capacitors that store a charge related to a peak voltage from output voltage signal $V_{out}$. In alternate embodiments of method 800 steps 842, 844, 846, and 848 may be performed with analog-to-digital converts and digital buffers.

In step 850, averaging stored values is performed by any component or device capable of averaging stored values. In an exemplary embodiment, averaging is performed by combining stored charges in capacitors, converting the combined charges to a voltage, and amplifying /attenuating the voltage to an appropriate level to produce a DC offset voltage. After averaging the stored values to produce the DC offset voltage 850, the DC offset voltage may be a level suitable for feeding back through a resistor.

In step 860, the DC voltage is provided as a feedback voltage to a charge amplifier in any manner. In an exemplary embodiment, the average of the stored values from step 850 may be fed back through a resistor as a feedback input to drive the output voltage in step 820. The resistor may be a resistor implemented as part of an integrated circuit on chip such as first resistor 132 in the exemplary embodiment of FIG. 3. In alternative embodiments, the resistor may be other types or forms of resistors, and may be implemented in various ways. Step 860 may include other functions as part of a feedback loop before feeding the voltage as an input to drive the output voltage in step 820.

Various systems, techniques and structures have therefore been described to improve the characteristics of charge amplifiers including blocking components of feedback around the carrier frequency in the DC feedback loop and the resulting phase error of the charge amplifier. In exemplary embodiments, a sampler in the DC feedback path of the charge amplifier substantially blocks AC signals, thereby lowering phase error introduced into a system by the charge amplifier. Further, in exemplary embodiments, leakage current can be supplied through a resistor implemented on chip as part of an integrated circuit, thereby reducing the overall cost of implementing a charge amplifier.

Systems, devices, and methods may therefore be configured in accordance with many different exemplary embodiments. In one embodiment, a charge amplifier circuit includes a first amplifier having a first amplifier input and a first amplifier output and a first capacitor coupled in parallel to the first amplifier. The exemplary charge amplifier also includes a DC feedback loop coupled in parallel to the first amplifier and coupled in parallel to the first capacitor. The DC feedback loop includes a sampler comprising a sampler input coupled to the first amplifier output, and a sampler output. The sampler receives an AC signal with a DC offset at the sampler input and drives a DC voltage substantially equal to the DC offset at the sampler output. The DC feedback loop in the exemplary embodiment also includes a first resistor coupled between the sampler output, and the first amplifier input.

This charge amplifier circuit may be modified, enhanced, and/or more fully defined in many different ways. The charge amplifier, for example, may have a comparator comprising a comparator input coupled to the first amplifier output and a comparator output, wherein the comparator output is a synchronized clock signal, synchronized with the first amplifier output. The sampler may include a sampler clock input, and the DC feedback loop may include a phase shifter comprising a phase shifter input coupled to the comparator output, and a phase shifter output coupled to the sampler clock input. In one embodiment the phase shifter delays the comparator output by substantially ninety degrees. The phase shifter may be selected, for example from a group consisting of: an integrator, a differentiator, a phase-locked-loop, and a Hilbert transformer. The sampler may be synchronized with a signal at the first amplifier output, and may store a first value from a first point on the AC signal. The sampler may also store a second value from a second point on the AC signal, with the first point and the second point being approximately one-hundred-eighty degrees apart. In one embodiment, the first point on the AC signal is a high peak, and the second point on the AC signal is a low peak. The sampler may combine the first value with the second value to produce the DC voltage, and the DC offset may be approximately equal to an average of the first value and the second value. The sampler may be configured to sample the AC signal with DC offset over a time period by sampling a first value from a first point on the AC signal, and sampling a second value from a second point on the AC signal. A charge amplifier may also include a second amplifier having a second amplifier input, and a second amplifier output, with the sampler output coupled to the second amplifier input and the second amplifier output coupled to the first resistor.

In still other embodiments, a method of operating a charge amplifier circuit is provided with the charge amplifier circuit having a circuit input and a circuit output. An output voltage signal is driven at the circuit output that is based upon an input charge signal. The output voltage signal is sampled over a time period to derive a DC offset voltage, and the DC offset voltage is fed back to the circuit input though a feedback resistor.

This basic technique may be modified, enhanced, and/or more fully defined in many ways. For example, a clock signal may be synchronized to the output voltage signal, wherein the sampling is synchronized to the output voltage signal using the clock signal. The output voltage signal may include a carrier frequency, and the sampling may includes a sampling rate, with the sampling rate being at least twice the carrier frequency. The input charge signal may be provided by a MEMS gyroscope. The sampling of the output voltage signal may include synchronizing a clock signal to the output voltage signal and shifting the clock signal with a phase shifter, wherein the phase shifter correlates a shifted clock signal to a high peak and a low peak in the output voltage signal. The output voltage signal may be sampled at the high peak and stored as a high stored value. The output voltage signal may be sampled at the low peak and stored as a low stored value. The high stored value and the low stored value may be averaged to produce an offset value. The DC offset voltage may be driven based on the offset value.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

As used herein, the word "exemplary" means "serving as an example, instance, or illustration", rather than as a "model" that would be exactly duplicated. Any implementation described herein as exemplary is not necessarily to be construed as preferred or advantageous over other implementations. Furthermore, there is no intention to be bound by any expressed or implied theory presented in the preceding technical field, background, brief summary or detailed description.

As used herein, the term "substantially" is intended to encompass any slight variations due to design or manufacturing imperfections, device or component tolerances, environmental effects and/or other factors. The term "substantially" also allows for variation from a perfect or ideal case due to parasitic effects, noise, and other practical considerations that may be present in an actual implementation.

The foregoing description may refer to elements or nodes or features being "connected" or "coupled" together. As used herein, unless expressly stated otherwise, "connected" means that one element/node/feature is electrically, mechanically, logically or otherwise directly joined to (or directly communicates with) another element/node/feature. Likewise, unless expressly stated otherwise, "coupled" means that one element/node/feature may be mechanically, electrically, logically or otherwise joined to another element/node/feature in either a direct or indirect manner to permit interaction even though the two features may not be directly connected. That is, "coupled" is intended to encompass both direct and indirect joining of elements or other features, including connection with one or more intervening elements.

In addition, certain terminology may also be used in the following description for the purpose of reference only, and thus are not intended to be limiting. For example, the terms "first", "second" and other such numerical terms referring to structures or elements do not imply a sequence or order unless clearly indicated by the context.

For the sake of brevity, conventional techniques related to charge amplifier design, MEMS gyroscopes and accelerometers, automatic gain control, and other functional aspects of the systems (and the individual operating components of the systems) may not be described in detail herein. Furthermore, the connecting lines shown in the various figures contained herein are intended to represent exemplary functional relationships and/or physical couplings between the various elements. It should be noted that many alternative or additional functional relationships or physical connections may be present in an embodiment of the subject matter. Further, the components of the various embodiments may be implemented on a chip using any number of transistors or other nonlinear gain elements. It should be understood that all circuitry described herein may be implemented either in silicon or another semiconductor material or alternatives by software code representation of silicon or another semiconductor material.

**Claims**

1. A method of operating a charge amplifier circuit (100) having a circuit input (112) and a circuit output (114), the method comprising:

   driving an output voltage signal (820) at the circuit output that is based upon an input charge signal;
   sampling the output voltage signal (842, 846) over a time period to derive a DC offset voltage;
   feeding back the DC offset voltage (860) to the circuit input though a feedback resistor;
   wherein the sampling the output voltage signal comprises:

      synchronizing a clock signal to the output voltage signal (830);
      shifting the clock signal with a phase shifter, wherein the phase shifter correlates a shifted clock signal to a high peak and a low peak in the output voltage signal;
sampling the output voltage signal at the high peak (842) and storing as a high stored value (844);
sampling the output voltage signal at the low peak (846) and storing as a low stored value (848);
averaging the high stored value with the low stored value (850) to produce an offset value; and
driving the DC offset voltage based on the offset value.

2. A method of operating a charge amplifier according to claim 1, wherein the output voltage signal includes a carrier frequency and the sampling includes a sampling rate, wherein the sampling rate is at least twice the carrier frequency.

3. A method of operating a charge amplifier according to claim 1, wherein the input charge signal is provided by a MEMS gyroscope (20).

**Patentansprüche**

1. Verfahren zum Betreiben eines Ladungsverstärkerschaltkreises (100), der einen Schaltkreiseingang (112) und einen Schaltkreisausgang (114) aufweist, wobei das Verfahren umfasst:

Steuern eines Ausgangsspannungssignals (820) an dem Schaltkreisausgang, welches auf einem Eingangsladungssignal basiert;
Abtasten des Ausgangsspannungssignals (842, 846) über ein Zeitintervall hinweg, um eine Offset-Gleichspannung abzuleiten;
Rückkoppeln der Offset-Gleichspannung (860) an den Schaltkreiseingang durch einen Rückkopplungswiderstand;
wobei das Abtasten des Ausgangsspannungssignals umfasst:

Synchronisieren eines Taktsignals mit dem Ausgangsspannungssignal (830);
Verschieben des Taktsignals mit einem Phasenschieber, wobei der Phasenschieber ein verschobenes Taktsignal mit einer hohen Spitze und einer niedrigen Spitze in dem Ausgangsspannungssignal korreliert;
Abtasten des Ausgangsspannungssignals in der hohen Spitze (842) und Abspeichern als ein hoher gespeicherter Wert (844);
Abtasten des Ausgangsspannungssignals in der niedrigen Spitze (846) und Abspeichern als ein niedriger gespeicherter Wert (848);
Mitteln des hohen gespeicherten Werts mit dem niedrigen gespeicherten Wert (850), um einen Offset-Wert zu erzeugen; und
Steuern der Offset-Gleichspannung auf der Grundlage des Offset-Werts.

2. Verfahren zum Betreiben eines Ladungsverstärkerschaltkreises (100), nach Anspruch 1, wobei das Ausgangsspannungssignal eine Trägerfrequenz aufweist und das Abtasten eine Abtastrate aufweist, wobei die Abtastrate mindestens doppelt so hoch wie die Trägerfrequenz ist.

3. Verfahren zum Betreiben eines Ladungsverstärkerschaltkreises (100), nach Anspruch 1, wobei das Eingangsladungssignal von einem MEMS-Gyroskop (20) bereitgestellt wird.

**Revendications**

1. Procédé de fonctionnement d'un circuit d'amplification de charge (100) ayant une entrée de circuit (112) et une sortie de circuit (114), le procédé comprenant :

le pilotage (820) d'un signal de tension de sortie à la sortie du circuit, qui est effectué en fonction d'un signal de charge d'entrée ;
l'échantillonnage (842, 846) du signal de tension de sortie sur une période de temps, afin d'en dériver une tension de décalage en courant continu ;
le renvoi par rétroaction (860) de la tension de décalage en courant continu vers l'entrée du circuit, par l'intermédiaire d'une résistance de rétroaction,
dans lequel l'échantillonnage du signal de tension de sortie comprend :

la synchronisation (830) d'un signal d'horloge et du signal de tension de sortie ;

le décalage du signal d'horloge avec un circuit de décalage de phase, le circuit de décalage de phase établissant une corrélation entre d'une part un signal d'horloge décalé et d'autre part un pic élevé et un pic bas dans le signal de tension de sortie ;

l'échantillonnage (842) du signal de tension de sortie au niveau du pic haut et le stockage (844) en tant que valeur stockée élevée ;

l'échantillonnage (846) du signal de tension de sortie au niveau du pic bas et le stockage (848) en tant que valeur stockée basse ;

la détermination (850) de la moyenne de la valeur stockée élevée et de la valeur stockée basse afin de produire une valeur de décalage ; et

le pilotage de la tension de décalage en courant continu sur la base de la valeur de décalage.

2. Procédé de fonctionnement d'un circuit d'amplification de charge selon la revendication 1, dans lequel le signal de tension de sortie inclut une fréquence porteuse et l'échantillonnage comporte une fréquence d'échantillonnage, dans lequel la fréquence d'échantillonnage est égale à au moins deux fois la fréquence porteuse.

3. Procédé de fonctionnement d'un circuit d'amplification de charge selon la revendication 1, dans lequel le signal de charge d'entrée est fourni par un gyroscope de technologie MEMS.

**FIG. 1**

**FIG. 2**

**FIG. 3**

**FIG. 4**

**FIG. 5**

FIG. 6

FIG. 7

EP 2 211 458 B1

**800**

```
┌─────────────┐          ┌──────────────────────────────┐
│             │          │                              │
│   MEMS      │─────────▶│   RECEIVE INPUT CHARGE        │╮  810
│   sensor    │          │                              │
│             │◀─────────│──────────────────────────────┘
│             │          ┌──────────────────────────────┐
│             │◀─────────│   DRIVE OUTPUT VOLTAGE SIGNAL │◀───┐
└─────────────┘          └──────────────────────────────┘    │
     20                    Vₒᵤₜ                  820         │
```

$V_{out}$

```
        ┌──────────────────────────────────┐
        │   SYNCHRONIZE OUTPUT VOLTAGE      │
        │         WITH SAMPLER              │
        └──────────────────────────────────┘ ╮ 830
           │                          │
           ▼                          ▼
    ┌──────────────┐          ┌──────────────┐
    │   SAMPLE     │          │   SAMPLE     │
    │  HIGH PEAK   │          │  LOW PEAK    │
    └──────────────┘          └──────────────┘
            842                       846
           │                          │
           ▼                          ▼
    ┌──────────────┐          ┌──────────────┐
    │   STORE      │          │   STORE      │
    │  HIGH PEAK   │          │  LOW PEAK    │
    └──────────────┘          └──────────────┘
            844                       848
           │                          │
           ▼                          ▼
    ┌──────────────────────────────────────┐
    │       AVERAGE STORED VALUES           │
    └──────────────────────────────────────┘
                                   850
                   │
                   ▼
    ┌──────────────────────────────────────┐
    │       FEEDBACK DC VOLTAGE             │
    └──────────────────────────────────────┘
                                   860
```

# FIG. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0325903 A